(19) **Europäisches Patentamt / European Patent Office / Office européen des brevets**

(11) **EP 1 445 996 B1**

(12) **EUROPEAN PATENT SPECIFICATION**

(45) Date of publication and mention
of the grant of the patent:
**20.08.2008 Bulletin 2008/34**

(51) Int Cl.:
***H05K 3/46*** (2006.01)

(21) Application number: **04011285.6**

(22) Date of filing: **23.10.1996**

(54) **Build-up multilayer printed circuit board**

Aufgebaute mehrschichtige Leiterplatte

Panneau à circuit imprimé multicouche édifié

(84) Designated Contracting States:
**DE FI GB NL**

(30) Priority: **23.10.1995 JP 27392895**
**10.11.1995 JP 31746995**
**24.06.1996 JP 16340296**

(43) Date of publication of application:
**11.08.2004 Bulletin 2004/33**

(60) Divisional application:
**06014607.3 / 1 705 973**

(62) Document number(s) of the earlier application(s) in
accordance with Art. 76 EPC:
**96935417.4 / 0 800 336**

(73) Proprietor: **IBIDEN CO., LTD.**
**Ogaki-shi, Gifu 503 (JP)**

(72) Inventors:
• **Kawamura, Yoichiro**
**Ibi-gun Gifu 501-06 (JP)**
• **Murase, Hideki**
**Ibi-gun Gifu 501-06 (JP)**
• **Asai, Motoo**
**Ibi-gun Gifu 501-06 (JP)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**EP-A- 0 653 904**      **GB-A- 2 283 617**
**US-A- 3 953 664**      **US-A- 4 555 532**
**US-A- 5 450 290**

• **"FORMATION OF SURFACE LAMINAR CIRCUIT ON PRINTED CIRCUIT BOARD WITH PLATED THROUGH HOLES" IBM TECHNICAL DISCLOSURE BULLETIN, IBM CORP. NEW YORK, US, vol. 36, no. 10, 1 October 1993 (1993-10-01), page 511 XP000412466 ISSN: 0018-8689**
• **PATENT ABSTRACTS OF JAPAN vol. 1995, no. 01, 28 February 1995 (1995-02-28) -& JP 06 302956 A (SUMITOMO BAKELITE CO LTD; OTHERS: 02), 28 October 1994 (1994-10-28)**
• **PATENT ABSTRACTS OF JAPAN vol. 016, no. 567 (E-1296), 8 December 1992 (1992-12-08) -& JP 04 217389 A (NIPPON CHEMICON CORP), 7 August 1992 (1992-08-07)**

**Description**

TECHNICAL FIELD

This invention relates to a resin filler and a multilayer printed circuit board, and more particularly it proposes a resin filler having various merits that the resistance to chemicals is excellent and the interlaminar peel is not caused and the occurrence of crack and peel due to cool-heat shock is prevented, and a multilayer printed circuit board having an excellent reliability by filling such a resin filler in concave portions created on the surface of a substrate or in a through-hole formed in the substrate to smoothen the surface of the substrate.

BACKGROUND ART

Recently, so-called build-up multilayer printed circuit boards are noticed as a multilayer printed circuit board from a demand for high densification. The build-up multilayer printed circuit board is manufactured, for example, by a method described in JP-B-4-55555. According to this method, an uncured resin insulating material consisting of a photosensitive adhesive for electroless plating is first applied onto a core substrate by means of a roll coater or the like, dried, exposed to a light and developed to form an interlaminar insulating layer having openings for viaholes. Then, the surface of the interlaminar insulating layer is roughened by treating with an oxidizing agent or the like, and a plating resist is formed on the roughened surface, and thereafter a portion not forming the resist is subjected to an electroless plating to form a conductor circuit pattern including a viahole. It is a method of producing the build-up multilayer printed circuit board by repeating such steps several times.

In such a method of producing the build-up multilayer printed circuit board, a conductor circuit or a through-hole is formed in the core substrate. The conductor circuit is formed in pattern by etching a copper foil attached to the surface of the core substrate through the build-up process, so that a concave portion is caused between the conductor circuits. Therefore, when the interlaminar insulating material is applied to the surface of,the core substrate while holding a state of the concave portion produced on the surface between the conductor circuits or the through-hole formed in the substrate, a recess (concave portion) is caused on the surface of the resulting interlaminar insulating layer at a position corresponding to the concave portion or the through-hole. This recess (concave portion) is developed on a surface of the multilayer printed circuit board as'a final product, which results in a poor connection when an electronic component is mounted thereonto.

On the contrary, there is a method of filling an epoxy resin paste in the concave portion such as through-hole or the like as a technique for solving the occurrence of the above concave portion as disclosed in JP-A-63-137499. In such a conventional method, the epoxy resin paste used as a filling resin is generally adjusted to a given viscosity by diluting with a solvent prior to the filling. Therefore, as described on page 2, left lower column of JP-A-63-137499, such a resin filler is required to be dried for the removal of the solvent after the filling.

However, it is very difficult to completely remove the solvent from the filling resin. For this end, when the solvent remains in the resin filler, if the interlaminar insulating layer is formed by applying the interlaminar insulating material onto the surface of the resin filler filled in the through-hole or the like formed in the core substrate and curing it under heating as in the build-up multilayer printed circuit board, the solvent remained in the resin filler evaporates to push up the interlaminar insulating layer and hence there is a problem of causing interlaminar peeling.

In the method of producing the build-up multilayer printed circuit board, the viahole is formed by exposing the photosensitive interlaminar insulating layer to a light and developing it. In the formation of the viahole, the exposure conditions are largely affected by the thickness of the interlaminar insulating layer. Therefore, if the thickness of the interlaminar insulating layer becomes ununiform due to surface unevenness resulted from the concave portion between the conductor circuits or the through-hole formed in the core substrate, the exposure and development conditions can not be made constant and hence there is a problem of causing the poor formation of the viahole.

In order to solve these problems, it is necessary to uniformize the thickness of the interlaminar insulating layer, and it is required to smoothen the surface of the core substrate as a premise. For this purpose, it is required that the surface of the substrate after the filling is polished in addition to the filling of the resin in the concave portion between the conductor circuits or the through-hole.

Therefore, the resin to be filled in the concave portion between the conductor circuits or the through-hole must be a resin capable of easily conducting the polishment and hardly causing cracks and the like by polishing. Further, it is desirable that the resin filled in the concave portion between the conductor circuits or the through-hole has various merits that the resistance to chemicals and hygroscopicity are excellent, and the interlaminar peeling is not caused, and cracks or peels due to cool-heat shock is not caused.

As such a filling resin, arbitrary epoxy resin may be selected if it is laminated together with a prepreg as in the wiring substrate described in JP-A-63-137499.

In the build-up multilayer printed circuit board, however, arbitrary epoxy resin can not be selected and applied as a resin filler to be filled in the concave portion between the conductor circuits or the through-hole because there are problems that cracks are created in the filling resin, conductor or interlaminar insulating resin by a reliability test such as thermal shock test (low-temperature, high-temperature cycle test) or the like and a plating solution or another treating solution penetrates into the concave portion or the through-hole from a gap produced by shrinkage of the resin under curing.

The invention is to propose a construction for solving the aforementioned problems inherent to the field of the invention inevitably produced when the resin filler is filled in the concave portion between the conductor circuits or the through-hole.

It is a main object to propose a resin filler suitable for filling in the concave portion created on the surface of the wiring substrate or the through-hole formed in the substrate and a construction of a build-up multilayer printed circuit board having an excellent reliability obtained by smoothening the surface of the substrate filled with the resin filler.

It is another object of the invention to propose a construction of a resin filler favorably used in the build-up multilayer printed circuit board having various merits that the resistance to chemicals is excellent, interlaminar peeling is not caused and cracks or peels due to cool-heat shock are not created.

It is the other object of the invention to propose a construction of a multilayer printed circuit board having excellent adhesion property between inner wall of through-hole and resin filler and reliability capable of controlling the occurrence of cracks and penetration of plating solution or the like.

US, 3, 953, 664 discloses an improved printed circuit board having at least two conductors, one conductor being on one surface of the circuit board and the other conductor being on the opposite surface of the circuit board. At least one hole extends therethough and a conductive layer extends through the hole. A filler composed of electrically insulating resin fills the hole and covers the surface of the layer.

EP 0138209 discloses an epoxy resin composition containing as a latent hardener a diaminotriazine-modified imidazole compound and dicyandiamide.

## DISCLOSURE OF THE INVENTION

The inventors have made various studies in order to achieve the above objects. As a result, the inventors have accomplished the invention constructed as set forth in claim 1.

## BRIEF DESCRIPTION OF THE DRAWINGS

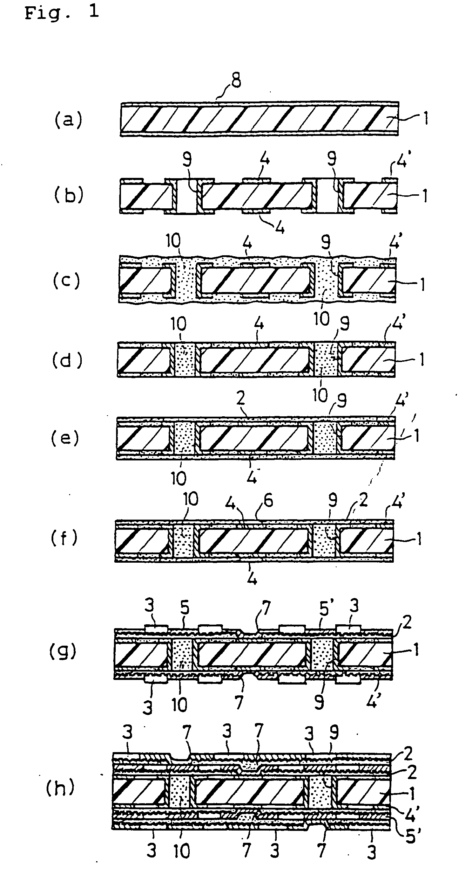

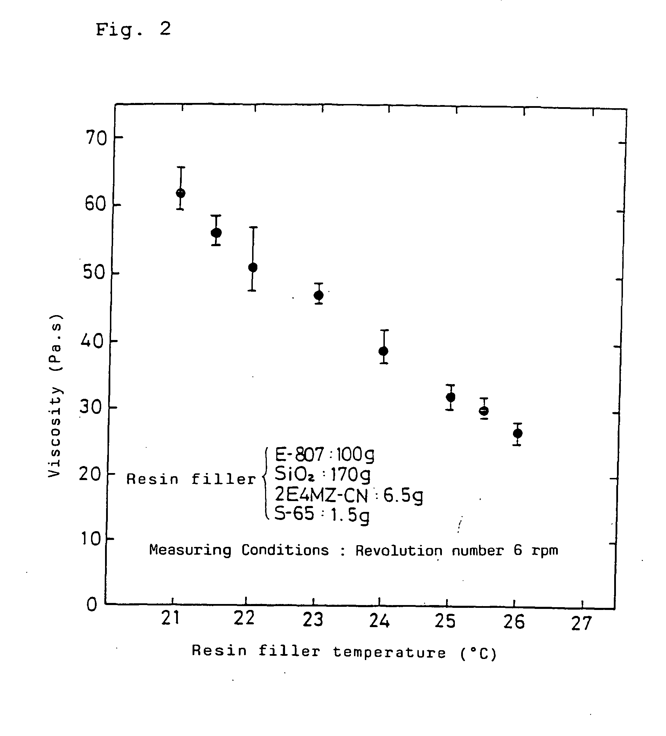

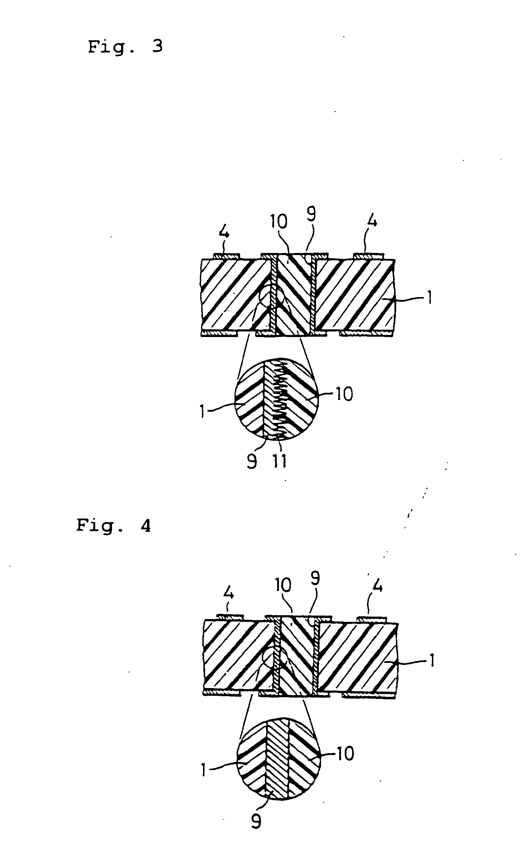

Fig. 1 is a flow chart showing the production steps of the multilayer printed circuit board using the resin filler according to the invention. Fig. 2 is a graph showing a relation between viscosity of resin filler and measuring temperature. Fig. 3 is a partial section view illustrating a construction of a through-hole in the multilayer printed circuit board according to the invention. Fig. 4 is a partial section view illustrating a construction of a through-hole in the conventional multilayer printed circuit board.

Here, numeral 1 is a substrate, numeral 2 an adhesive layer (interlaminar insulating layer), numeral 3 a plating resist (permanent resist), numerals 4, 4' innerlayer copper patterns, numeral 5, 5' outerlayer conductor layers, numeral 6 an opening for viahole, numeral 7 a viahole, numeral 8 a copper foil, numeral 9 a through-hole, numeral 10 a resin filler and numeral 11 a roughened layer.

## BEST MODE FOR CARRYING OUT THE INVENTION

The resin filler according to the invention mainly lies in a solvent-free filling material. Therefore, the resin filler according to the invention does not cause problems resulted from the evaporation of the solvent even when the filler is filled in the concave portion (between conductor circuits or viahole) created on the surface of the substrate or in the through-hole formed in the substrate and the resin insulating material is applied thereto and then dried and cured under heating. That is, according to the invention, the peeling between the layer of the resin filler for smoothening the surface of the substrate and the resin insulating layer formed thereon can be prevented. Further, the resin filler according to the invention does not shrink through the drying for the removal of the solvent, so that the problems such as recess formed through the shrinkage and the like can be solved.

The resin filler according to the invention lies in a point that bisphenol type epoxy resin is used as a resin component. Thus, the resin filler using such an epoxy resin is low in the viscosity, so that the viscosity can be adjusted to a given range without diluting with a solvent and hence it is possible to sufficiently fill in the concave portion (between conductor circuits or viahole) created on the surface of the substrate or in the through-hole formed in the substrate.

In the resin filler according to the invention using the epoxy resin, it is desirable to adjust the viscosity to a range of $0.3 \times 10^5$-$1.0 \times 10^5$ cps (30-100 Pa·s) at a temperature of $23 \pm 1°C$. When the viscosity is too high, the filling operation of the resin filler is difficult, while when it is too low, the resin filler.is apt to be flowed out and the satisfactory filling can not be attained. Moreover, the adjustment of the viscosity in the resin filler is carried out by the amount of the curing agent added, or the average particle size or amount of the inorganic particles added. And also, the viscosity of the resin filler can be adjusted by the temperature in the filling operation.

When the bisphenol type epoxy resin is used as the resin component, the epoxy resin after the curing through polymerization is rich in the flexibility as compared with novolac type epoxy resin having a rigid skeleton. Therefore, the polishing operation of the substrate surface after the filling and curing of the resin filler becomes easy and the cracking is hardly caused through the polishing.

As the bisphenol type epoxy resin, bisphenol A-type epoxy resin and bisphenol F-type epoxy resin are desirable. Particularly, the bisphenol F-type epoxy resin is preferable from a viewpoint of viscosity adjustment. In the bisphenol F-type epoxy resin, hydrogen bonds to carbon between phenyl groups instead of methyl group, so that the molecular chain is easy in the motion and the fluidity is rich at an uncured state, while the flexibility is rich at a cured state.

Further, the resin filler according to the invention lies in the use of an imidazole curing agent. The epoxy resin obtained by curing the above epoxy resin (monomer or oligomer) as a resin component of the resin filler with the imidazole curing agent through polymerization is excellent in the heat resistance, resistance to chemicals and resistance to oxidizing agent or base. As a result, the resin filler according to the invention becomes excellent in the heat resistance, resistance to chemicals and resistance to oxidizing agent and base at a cured state. Particularly, the resin filler according to the invention is advantageous in the production of the build-up multilayer printed circuit board in which the surface of the interlaminar insulating layer is subjected to a roughening treatment with an oxidizing agent or to a plating treatment by immersing in a strong base electroless plating solution. Because, the epoxy resin cured using a curing agent other than the imidazole curing agent is decomposed by the above treatment.

And also, the epoxy resin cured with the imidazole curing agent through polymerization is hydrophobic, and hardly absorbs water. Therefore, the insulation resistance between the conductor circuits formed on the wiring substrate never lowers due to the water absorption by the filled resin filler.

As the imidazole curing agent, mention may be made of 2-methyl imidazole (trade name: 2MZ), 4-methyl-2-ethyl imidazole (trade name: 2E4MZ), 2-phenyl imidazole, (trade name: 2PZ), 4-methyl-2-phenyl imidazole (trade name: 2P4MZ), 1-benzyl-2-methyl imidazole (trade name: 1B2MZ), 2-ethyl imidazole (trade name: 2EZ), 2-isopropyl imidazole (trade name: 2IZ), 1-cyanoethyl-2-methyl imidazole (trade name: 2MZ-CN),1-cycanoethyl-2-ethyl-4-methylimidazole (trade name: 2E4MZ-CN), 1-cyanoethyl-2-undecyl imidazole (trade name: $C_{11}Z$-CN) and the like.

Particularly, it is desirable to use an imidazole curing agent being liquid at 25°C, which includes, for example, 1-benzyl-2-methyl imidazole (trade name: 1B2MZ), 1-cyanoethyl-2-ethyl-4-methyl imidazole (trade name: 2E4MZ-CN) and 4-methyl-2-ethyl imidazole (trade name: 2E4MZ). In the invention, the solvent-free resin component is used, so that it is difficult to uniformly knead the resin component with the powdery imidazole curing agent, while the uniform kneading of the resin component with the liquid imidazole curing agent is easy.

It is desirable that the amount of the imidazole curing agent in the resin filler is 1-10% by weight because when it is within the above range, the viscosity of the resin filler is easily adjusted.

In the resin filler according to the invention, it is desirable that 60-80% of all monomer is reacted in the curing treatment after the filling. When the reaction rate is adjusted to the above range, the resin hardness enough to easily conduct the polishing is obtained.

The resin filler according to the invention lies in that inorganic particles are contained as an additive component in the main construction including the resin component and the imidazole curing agent. Thus, the shrinkage of the resin filler through the curing is less and the warping of the core substrate is not caused. Further, the cured resin filler is small in the linear thermal expansion coefficient and excellent in the resistance to heat cycle.

That is, the epoxy resin obtained by curing the bisphenol type epoxy resin constituting the resin filler according to the invention through polymerization is easy in the polishing and flexible as compared with the novolac type epoxy resin having a rigid skeleton, but is not small in the curing shrinkage and thermal expansion coefficient. In this point, the resin filler according to the invention added with the inorganic particles as an additive component can solve problems resulted from the curing shrinkage and thermal expansion coefficient and becomes an optimum resin filler in the build-up multilayer printed circuit board. Further, the inorganic particles do not absorb water, so that the water absorption of the resin filler can be reduced and hence the lowering of the insulation resistance between the conductor circuits due to the absorption of water by the resin filler can be prevented.

As the inorganic particle, mention may be made of silica, alumina, mullite, zirconia and the like.

The inorganic particles are desirable to have an average particle size of 0.1-5.0 $\mu$m. When the particle size is too fine, the viscosity of the resin filler is too high and the filling operation is difficult, while when it is too rough, the smoothness of the surface is lost.

The amount of the inorganic particles compounded is desirable to be about 1.0-2.0 times that of the bisphenol type epoxy resin. When the amount of the inorganic particles is within the above range, the viscosity of the resin filler is easily adjusted to about $0.3\times10^5$-$1.0\times10^5$ cps (30-100 Pa·s) at $23\pm1$°C.

A concrete example of applying the resin filler according to the invention to the build-up multilayer printed circuit board will be described below.

That is, the build-up multilayer printed circuit board formed by alternately laminating interlaminar insulating layer and conductor layer on a surface of a wiring substrate provided with a conductor circuit or a through-hole and electrically connecting the conductor layers through a viahole formed in the interlaminar insulating layer is produced through at least steps comprising:

(1) a step of applying and filling the resin filler according to the invention onto a concave portion created on a surface of a wiring substrate or a through-hole formed in the substrate;
(2) a step of curing the resin filler filled at the item (1) ;
(3) a step of polishing the surface portion of the resin filler cured at the item (2) to expose conductor circuit (inclusive of land portion of a viahole) and land portion of the through-hole and hence smoothen the surface of the substrate;
(4) a step of forming an interlaminar insulating layer; and
(5) a step of forming conductor circuit on the surface of the interlaminar insulating layer.

The step (1) is a step of applying and filling the resin filler according to the invention onto a concave portion created on a surface of a wiring substrate or a through-hole formed in the substrate.

In this step, the resin filler is applied to and filled in at least one portion selected from portion between conductor circuits or through-hole formed in the core substrate and portion between conductor circuits or viahole formed in the interlaminar insulating layer.

The step (2) is a step of curing the resin filler filled at the step (1).

In this step, it is desirable that the resin filler is at a polishable state ( state of curing 60%-80% of all monomer) but is not at a completely cured state. Because the polishing is easy.

Particularly, when the resin filler according to the invention contains inorganic particles, the shrinkage through curing is less and the warping of the substrate is not caused. If the resin filler is filled while contacting with a metal conductor, cracks are apt to be generated due to the difference of thermal expansion coefficient between metal and resin in the heat cycle. In this connection, the resin filler according to the invention including the inorganic particles is small in the thermal expansion coefficient at the cured state, so that the occurrence of cracks by heat cycle can be controlled.

The step (3) is a step of polishing the surface portion of the resin filler cured at the step (2) to expose conductor circuit, land portion of the through-hole and land portion of the viahole and smoothen the surface of the substrate. Because the adhesion of the filled resin to the conductor circuit or land portion results in the poor conduction.

Moreover, the polishing method is preferable to be a buff polishing, a belt sander or the like.

The step (4) is a step of forming the interlaminar insulating layer.

The interlaminar insulating layer is comprised of two layers, in which a lower layer is composed of a heat-resistant resin hardly soluble in an acid or oxidizing agent and an upper layer is composed of an adhesive for electroless plating obtained by dispersing cured resin particles soluble in an acid or oxidizing agent into a heat-resistant resin matrix hardly soluble in an acid or oxidizing agent. The layer of the adhesive for electroless plating as an upper layer is roughened by dissolving and removing cured resin particles existing on the surface of the layer with the acid or oxidizing agent to improve the adhesion property to a conductor formed on the roughened surface, while the layer of the heat-resistant resin as a lower layer is made from the resin hardly soluble in the acid or oxidizing agent and prevents the arrival of the acid or oxidizing agent for the dissolution of the upper layer at a conductor located below the lower layer.

Further, the interlaminar insulating layer is formed on the smoothened surface of the substrate, so that the thickness of the interlaminar insulating layer can be uniformized. In case of forming the viahole, therefore, the interlaminar insulating layer having a uniform thickness is formed by light exposure and development, so that any viaholes can be exposed to light under the same exposure conditions and there is caused no opening of the viahole, poor shape or the like.

Furthermore, the resin filler according to the invention is a solvent-free resin filler, so that the interlaminar peeling from the interlaminar insulating layer due to the evaporation of the solvent can be prevented.

The step (5) is a step of forming conductor circuit inclusive of viahole on the surface of the interlaminar insulating layer. That is, the surface of the interlaminar insulating layer is subjected to a roughening treatment with the acid or oxidizing agent and a catalyst nucleus is applied thereto and then a plating resist is formed and thereafter a non-resist forming portion is subjected to an electroless plating.

As the plating resist, use may be made of various substances including commercially available product, which includes, for example, an acrylate of novolac type epoxy resin such as phenol novolac, cresol novolac or the like.

Moreover, when the plating resist formed by an additive process is polished to smoothen the surface of the substrate, even if wiring layers are multilayered by additive process, the surface may always be smoothened.

The thud produced multilayer printed circuit board according to the invention is a multilayer printed circuit board formed by alternately laminating interlaminar insulating layer and conductor layer on a surface of a wiring substrate provided with a conductor circuit or a through-hole and electrically connecting the conductor layers through a viahole formed in the interlaminar insulating layer, in which a solvent-free resin filler comprising a bisphenol type epoxy resin as a resin component, an imidazole curing agent as a curing agent and inorganic particles as an additive component is filled in a concave portion created on the surface of the wiring substrate or in the through-hole formed in the substrate.

In the multilayer printed circuit board according to the invention, it is desirable that the roughened layer (uneven layer) is formed on the conductor surface in the inner wall of the through-hole for improving the adhesion property between the conductor surface in the inner wall of the through-hole and the resin filler.

Thus, ① there can surely be prevented the occurrence of cracks due to the expansion and shrinkage of in the reliability test such as cool-heat cycle test (-65˚C⇔125˚C), test for resistant to soldering (immersion test at 230˚C) or the like, and ② the gap at the boundary between the conductor in the inner wall of the through-hole and the resin filler is not created in the curing shrinkage of the resin, so that the penetration of the plating solution or the like can surely be controlled.

Moreover, the above roughened layer is formed on the surface of the conductor in addition to the inner wall of the through-hole, so that the adhesion property between the conductor and the insulating layer or solder resist is improved when the multilayer formation is conducted by forming the insulating layer or when the soldering resist is formed to supply a solder.

In the multilayer printed circuit board according to the invention, as the roughened layer formed on the conductor surface in the inner wall of the through-hole, there are needle-like alloy layer obtained by electroless copper-nickel-phosphorus plating or the like, blackened layer obtained by oxidation treatment of copper, blackened reduced layer obtained by oxidation and reduction treatments of copper, blown reduced layer, and physical roughened layer obtained by sand blast, shot blast, buff polishing, wrapping or the like.

Among them, the needle-like alloy layer obtained by electroless copper-nickel-phosphorus plating or the like is desirable. Because, such an alloy layer is excellent in the adhesion property to the resin filler owing to needle form, and also it is strong in the toughness, hard, and hardly cracks and is excellent in the heat cycle property. In this case, it is desirable that the amounts of copper, nickel and phosphorus constituting the copper-nickel-phosphorus alloy layer are about 90-96 wt%, 1-5 wt% and 0.5-2 wt%, respectively. When they are within the above range, the precipitated film has a needle structure and is excellent in the anchor effect.

The composition of the electroless plating bath for the formation of the needle-shaped alloy layer is desirable to be copper sulfate: 1-40 g/l, nickel sulfate: 0.1-6.0g/l, citric acid: 10-20 g/l, hypophosphate: 10-100 g/l, boric acid: 10-20 g/l and surfactant: 0.01-10 g/l. Particularly, the presence of the surfactant is necessary for rendering the alloy layer into needle shape and must satisfy the above range. When the amount is outside the above range, the plated film constituting the precipitated roughened layer is not dense and the heat cycle property considerably lowers.

As the electroless plating conditions, it is desirable that a temperature of a plating bath is 60-80˚C, pH is a strong base of about 8.5-10, a bath ratio is 0.01-1.0 dm$^2$/l, a precipitating rate is 1-3 $\mu$m/10 minutes and a plating time is 5-20 minutes.

The thus formed needle-shaped alloy layer is desirable to be a cooper-nickel-phosphorus alloy layer in which a thickness of roughened layer is 0.5-7.0 $\mu$m, preferably 1.0-5.0 $\mu$m, more particularly 1.5-3.0 $\mu$m. When the thickness of the roughened layer exceeds 7.0 $\mu$m, the long plating time is taken and the production cost and the material cost are increased and also the needle-shaped film itself becomes brittle and the space to the resin filler is apt to be created. While, when it is less than 0.5 $\mu$m, the anchor effect is insufficient and the space to the resin filler is apt to be created. Moreover, the term "thickness of the roughened layer (copper-nickel-phosphorus alloy layer)" means a distance from the smooth conductor surface in the inner wall of the through-hole to the top of the needle-shaped alloy.

In the invention, when the roughened layer formed in the inner wall of the through-hole is the electroless copper-nickel-phosphorus needle-shaped alloy layer or the like, it is desirable that the roughened layer is protected with a tin layer. Because, the alloy plated layer is apt to be dissolved in acid or oxidizing agent and hence the dissolution of the alloy plated layer is prevented to maintain the roughened layer. Furthermore, the tin layer can prevent the oxidation of the roughened layer to improve the wettability between the roughened layer and the filled resin and also can prevent the occurrence of the space between the roughened layer and the filled resin to improve the adhesion property and hence it is possible to control the occurrence of cracks and the like even when being applied to heat cycle or the like.

Moreover, tin is a metal being industrially cheap and less in the toxicity and does not cause color change through acid or oxidizing agent and can maintain the gloss. And also, it is a metal precipitated by the substitution reaction with copper and can cover the copper-nickel-phosphorus needle-shaped layer without breaking this layer.

Since tin is precipitated by the substitution reaction with copper, once it is substituted with copper on the surface layer, the substitution reaction is terminated to form a very thin film layer covering the needle alloy of the roughened layer. Therefore, the needle alloy of the roughened layer is maintained at its sharp form and hence the adhesion property between the roughened layer and tin plated film is excellent. (Example 1) (bisphenol F-type + silica)

Fig. 1 is a flow chart showing the production of the multilayer printed circuit board using a resin filler in an embodiment according to the invention. This example will be described with reference to Fig. 1.

(1) As a starting material, there is used a copper lined laminate plate obtained by laminating copper foil 8 of 18 $\mu$m on

both surfaces of a substrate 1 made from glass epoxy resin or BT (bismaleimide triazine) resin having a thickness of 1 mm (see Fig. 1(a)). At first, the copper lined laminate plate is drilled and a plating resist is formed thereon, which is subjected to an electroless plating treatment to form through-holes 9 and further the copper foil 8 is etched in a given pattern according to usual manner to form innerlayer copper patterns 4, 4' on both surfaces of the substrate 1 (see Fig. 1(b)).

(2) Separately, 100 parts by weight of bisphenol F-type epoxy resin (made by Yuka Shell Co., Ltd. molecular weight: 310, trade name: E-807) is mixed with 6 parts by weight of an imidazole curing agent (made by Shikoku Kasei Co., Ltd. trade name: 2E4MZ-CN) and further the resulting mixture is mixed with 170 parts by weight of $SiO_2$ spherical particles having an average particle size of 1.6 $\mu$m (the maximum size of the particles is not more than the thickness (15 $\mu$m) of an innerlayer copper pattern as mentioned below) and kneaded through three rolls to adjust a viscosity of the mixture to 45,000-49,000 cps at 23$\pm$1˚C (100,000 cps measured at 15$\pm$1˚C, see results shown in Fig. 2 as measured at a revolution number of 6 rpm by means of a rotating viscometer), whereby a resin filler 10 for smoothening the surface of the substrate is obtained.

This resin filler is solvent-free. If the resin filler containing a solvent is used, when an interlaminar material is applied and dried by heating at subsequent steps, the solvent evaporates from the resin filler layer to cause the peeling between the resin filler layer and the interlaminar material layer.

(3) The resin filler 10 obtained in the item (2) is applied onto both surfaces of the substrate 1 shown in Fig. 1(b) by using a roll coater to fill between the conductor circuits or in the through-holes and then cured by subjecting to a heat treatment at 150˚C for 30 minutes (see Fig. 1(c)). That is, the resin filler 10 is filled between the innerlayer copper patterns 4 and 4' or in the through-holes 9 at this step.

Moreover, the resin filler 10 is substantially completely crosslinked by the heat treatment at 150˚C for 3 hours to provide a resin having a high hardness. In this step, therefore, the resin filler 10 is cured to a range capable of conducting belt sander polishing or buff polishing in order to easily conduct the polishing operation of the resin filler 10.

(4) The one-side surface of the substrate shown in Fig. 1(c) after the treatment of the item (3) is polished by belt sander polishing using #600 belt polishing paper (made by Sankyo Rikagaku Co., Ltd.) in such a manner that the resin filler 10 is not left on the surfaces of the innerlayer copper patterns 4, 4' or the land surfaces of the through-holes 9, and then buff-polished so as to remove scratches formed by the belt sander polishing. Such a series of polishings is applied to the other-side surface of the substrate. Then, the resin filler 10 filled in the through-holes 9 or the like is completely crosslinked and cured by heating at 150˚C for 3 hours to obtain the substrate in which both surfaces of the substrate are smoothened with the resin filler 10 (see Fig. 1(d)). That is, the surface of the resin filler 10 and the surface of the innerlayer copper patterns 4, 4' are rendered into the same plane.

At this step, there can be adopted a method in which the belt sander polishing is carried out so as to slightly leave the resin filler 10 on the surface of the innerlayer copper pattern 4, 4' or the land surface of the through-hole 9 and then the buff polishing is conducted, or a method of conducting only the buff polishing. Further, the resin filler 10 containing $SiO_2$ spherical particles is small in the shrinkage through curing, so that the warping of the substrate is not caused. And also, the thermal expansion coefficient becomes small at a cured state, so that the resistance to heat cycle is excellent.

(5) On the other hand, a photosensitive adhesive solution is obtained by mixing 70 parts by weight of a 25% acrylated product of cresol novolac type epoxy resin (made by Nippon Kayaku Co., Ltd. molecular weight: 2500) dissolved in DMDG (diethylene glycol dimethylether), 30 parts by weight of polyether sulphone (PES), 4 parts by weight of an imidazole curing agent (made by Shikoku Kasei Co., Ltd. trade name: 2E4MZ-CN), 10 parts by weight of caprolacton-modified tris(acroxyethyl) isocyanuarate (made by Toa Gosei Co., Ltd. trade name: Aronix M325) as a photosensitive monomer, 5 parts by weight of benzophenone (made by Kanto Kagaku Co., Ltd.) as a photoinitiator, 0.5 part by weight of Micheler's ketone (made by Kanto Kagaku Co., Ltd.) as a photosensitizer, 35 parts by weight at 5.5 $\mu$m on average and 5 parts by weight at 0.5 $\mu$m of epoxy resin particles, adding NMP to adjust a viscosity to 12 Pa·s in a homodisper agitating machine and kneading them through three rolls.

(6) The substrate shown in Fig. 1(d) after the completion of the item (4) is washed with water, dried, acidically degreased and further soft-etched. Then, the substrate is immersed in a catalyst solution of palladium chloride and organic acid to give a Pd catalyst and activated and subjected to an electroless plating to form a roughened layer (uneven layer) of Cu-Ni-P alloy having a thickness of 2.5 $\mu$m on the surfaces of copper conductor and viahole pad. Further, the substrate is washed with water and immersed in an electroless tin plating bath of tin borofluoride-thiourea at 50˚C for 1 hour to form a tin-substituted plated layer having a thickness of 0.3 $\mu$m on the roughened layer of Cu-Ni-P alloy.

(7) The photosensitive adhesive solution obtained in the item (5) is applied onto both surfaces of the substrate after the treatment of the item (6) by means of a roll coater and left to stand at a horizontal state for 20 minutes and dried at 60˚C for 30 minutes to form an adhesive layer 2 having a thickness of 60 $\mu$m as shown in Fig. 1(e).

In this step, there may be adopted a structure that the insulating layer is formed on the resin filler layer and then the photosensitive adhesive layer is formed on the insulating layer as a structure other than that the photosensitive adhesive layer is directly formed on the resin filler layer. That is, there can be formed an interlaminar insulating layer consisting of the insulating layer and the adhesive layer. In this case, the insulating layer is obtained by mixing 70% by weight of 25% acrylated product of cresol novolac type epoxy resin (made by Nippon Kayaku Co., Ltd.), 25% by weight of polyether sulphone (made by Mitsui Toatsu Co., Ltd.), 4% by weight of benzophenone, 0.4% by weight of Micheler's ketone and an imidazole curing agent, adding normalmethyl pyrolidone (NMP) to adjust the viscosity to 30 Pa·s in a homodisper agitating machine and kneading through three rolls.

(8) A photomask film printed with black circles of 100 $\mu$m$\phi$ is adhered onto both surfaces of the substrate provided with the adhesive layer 2 in the item (7) and exposed to a superhigh pressure mercury lamp at 500 mJ/cm$^2$. It is developed by spraying DMDG solution to form openings for viaholes of 100 $\mu$m$\phi$ in the adhesive layer 2. Further, the substrate is exposed to a superhigh pressure mercury lamp at 3000 mJ/cm$^2$ and then heated to and heated at 100°C for 1 hour and at 150°C for 5 hours to form an interlaminar insulating layer (adhesive layer 2) of 50 $\mu$m in thickness having openings (openings 6 for the formation of viaholes) with an excellent size accuracy corresponding to the photomask film (see Fig. 1(f)). Moreover, the tin plated layer (not illustrated) is partly exposed in the opening 6 for the viahole.

(9) The substrate treated in the item (8) is immersed in chromic acid for 1 minute to dissolve and remove epoxy resin particles from the surface of the interlaminar insulating layer, whereby the surface of the interlaminar insulating layer is roughened. Thereafter, it is immersed in a neutral solution (made by Shipley) and washed with water. Further, a palladium catalyst (made by Atotec Co., Ltd.) is applied to the roughened surface of the substrate to give a catalyst nucleus to the surface of the interlaminar insulating layer and the inner wall face of the opening 6 for the viahole.

(10) A liquid resist is obtained by mixing a photosensitized oligomer (molecular weight: 4000) in which 25% of epoxy group in cresol novolac type epoxy resin (made by Nippon Kayaku Co., Ltd. trade name: EOCN-103S) dissolved in DMDG is acrylated, an imidazole curing agent (made by Shikoku Kasei Co., Ltd. trade name: 2PMHZ-PW), an acrylic isocyanate (made by Toa Gosei Co., Ltd. trade name: Aronix M215) as a photosensitive monomer, benzophenone (made by Kanto Kagaku Co., Ltd.) as a photoinitiator, and Micheler's ketone (made by Kanto Kagaku Co., Ltd.) with NMP according to the following composition, adjusting the viscosity to 3000 cps in a homodisper agitating machine and then kneading through three rolls.

```
Resin composition = photosensitive epoxy/M215/BP/Mk/imidazole
                  = 100/10/5/0.5/5
```

(11) The liquid resist is applied onto both surfaces of the substrate treated in the item (9) by means of a roll coater and dried at 60°C for 30 minutes to form a resist layer having a thickness of 30 $\mu$m. Then, a mask film pictured with a conductor circuit pattern of L/S (ratio of line to space) = 50/50 is adhered and exposed to a superhigh mercury lamp at 1000 mJ/cm$^2$ and developed by spraying DMDG to form a plating resist removing the conductor circuit pattern on the substrate, which is further exposed to a superhigh pressure mercury lamp at 1000 mJ/cm$^2$ and heated at 100°C for 1 hour and at 150°C for 3 hours to form a permanent resist 3 on the interlaminar insulating layer.

(12) The substrate provided with the permanent resist 3 is immersed in an aqueous solution of 100 g/l of sulfuric acid to activate the catalyst nucleus and thereafter a primary plating is carried out by using an electroless copper-nickel alloy plating bath having the following composition to form a copper-nickel-phosphorus plated thin film of about 1.7 $\mu$m in thickness on the resist non-formed portion. In this case, the temperature of the plating bath is 60°C and the plating immersion time is 1 hour.

| | | |
|---|---|---|
| Metal salts | $CuSO_4 \cdot 5H_2O$ | : 6.0 mM (1.5 g/l) |
| | $NiSO_4 \cdot 6H_2O$ | : 95.1 mM (25 g/l) |
| Complexing agent | $Na_3C_6H_5O_7$ | : 0.23 M (60 g/l) |
| Reducing agent | $NaPH_2O_2 \cdot H_2O$ | : 0.19 M (20 g/l) |
| pH adjusting agent | NaOH | : 0.75 M (pH=9.5) |
| Stabilizer | lead nitrate | : 0.2 mM (80 ppm) |
| Surfactant | | : 0.05 g/l |
| Precipitation rate | | : 1.7 $\mu$m/hr |

(13) The substrate subjected to the primary plating in the item (12) is taken out from the plating bath and washed with water to remove the plating solution adhered to the surface thereof and further treated with an acidic solution to remove oxide film from the surface of the copper-nickel-phosphorus plated film layer. Thereafter, the copper-nickel-phosphorus plated thin film layer is subjected to a secondary plating using an electroless copper plating bath having the following composition without Pd substitution to form overlayer conductor pattern 5, 5' and viahole (BVH) 7 required as a conductor layer through additive process (see Fig. 1(g)). In this case, the temperature of the plating bath is 50-70°C and the plating immersion time is 90-360 minutes.

| | | |
|---|---|---|
| Metal salt | CuSO$_4$·5H$_2$O | : 8.6 mM |
| Complex agent | TEA | : 0.15 M |
| Reducing agent | HCHO | : 0.02 M |
| Others | stabilizer (bipyridyl, potassium ferrocyanide) | : small |
| Precipitation rate | | : 6 $\mu$m/hr |

(14) After the conductor layer is formed through the additive process, the one-side surface of the substrate is polished by the belt sander polishing using the # 600 belt polishing paper likewise the step of the item (4) so as to align the surface layer of the permanent resist with the uppermost surface of the copper in the viahole. Subsequently, the buff polishing is carried out for removing the scratches created by the belt sander (only the buff polishing may be conducted). Further, the other-side surface is polished as mentioned above to form a printed wiring substrate having both smooth surfaces.

(15) The aforementioned steps are repeated to form a further one conductor layer through the additive process, whereby there is produced a multilayer printed circuit board having 6 built-up wiring layers (see Fig. 1(h)).

(Example 2) (bisphenol F-type)

(1) A resin filler having a viscosity of 35,000 cps at 23$\pm$ 1˚C is obtained by mixing 100 parts by weight of bisphenol F-type epoxy monomer and 6 parts by weight of an imidazole curing agent (made by Shikoku Kasei Co., Ltd. trade name: 2E4MZ-CN) and kneading through three rolls. This resin filler is a solvent-free resin filler.
(2) A printed circuit board is produced in the same manner as in Example 1.

(Comparative Example 1) (bisphenol A-type + solvent)

(1) A resin filler having a viscosity of 50,000 cps at 23$\pm$ 1˚C is obtained by mixing 100 parts by weight of bisphenol A-type epoxy monomer (made by Yuka Shell Co., Ltd.) and 6 parts by weight of an imidazole curing agent (made by Shikoku Kasei Co., Ltd. trade name: 2E4MZ-CN) and adding 170 parts by weight of SiO$_2$ spherical particles having an average particle size of 1.6 $\mu$m (the maximum size of the particle is not more than a thickness (15 $\mu$m) of an innerlayer copper pattern as mentioned below) together with NMP and kneading through three rolls.
(2) A printed circuit board is produced in the same manner as in Example 1.

(Comparative Example 2) (phenol novolac + solvent)

(1) A resin filler having a viscosity of 50,000 cps at 23$\pm$ 1˚C is obtained by mixing 100 parts by weight of phenol novolac type epoxy resin oligomer and 6 parts by weight of an imidazole curing agent (made by Shikoku Kasei Co., Ltd. trade name: 2E4MZ-CN) and adding 170 parts by weight of SiO$_2$ spherical particles having an average particle size of 1.6 $\mu$m (the maximum size of the particle is not more than a thickness (15 $\mu$m) of an inner layer copper pattern as mentioned below) together with NMP and kneading through three rolls.
(2) A printed circuit board is produced in the same manner as in Example 1.

(comparative Example 3) (phenol novolac + solvent + no inorganic particle)

(1) A resin filler having a viscosity of 50,000 cps at 23$\pm$ 1˚C is obtained by mixing 100 parts by weight of phenol novolac type epoxy resin oligomer and 6 parts by weight of an imidazole curing agent (made by Shikoku Kasei Co., Ltd. trade name: 2E4MZ-CN) with NMP and kneading through three rolls.
(2) A printed circuit board is produced in the same manner as in Example 1.

In the above Examples and Comparative Examples, the filling property of the resin filler, polishability of the resin filler, presence or absence of shrinkage through curing of the resin filler and presence or absence of interlaminar peel are measured in the production of the printed circuit board, and further the resistance to cool-heat shock and water absorption are measured with respect to the resulting printed circuit board. The results are shown in Table 1.

Table 1

|  | Example | | Comparative Example | | |
|---|---|---|---|---|---|
|  | 1 | 2 | 1 | 2 | 3 |
| Filling property of resin filler | ○ | ○ | ○ | ○ | ○ |
| Polishability of resin filler | ○ | ○ | ○ | X | X |
| Shrinkage through curing of resin filler | none | slight | presence | | |
| Interlaminar peel | none | none | presence | | |
| Resistance to cool-heat shock | ○ | X | ○ | ○ | X |
| Water absorption | ○ | X | ○ | ○ | X |

[Filling property of resin filler]

It is judged whether or not the resin filler is surely filled between the conductor circuits or in the through-hole by means of a roll coater.

[Polishability of resin filler]

In the polishing of the cured resin filler, it is judged whether or not notch or crack is created.

[Shrinkage through curing of resin filler]

It is judged whether or not the space is existent when the section of the through-hole portion formed in the substrate is observed by means of an optical microscope.

[Presence or absence of interlaminar peel]

The peeled state at the boundary between the resin filler layer and the adhesive layer or the insulating layer is confirmed by observing the section of the substrate by means of an optical microscope.

[Resistance to cool-heat shock]

It is judged by the presence or absence of cracks created in the conductor circuit or the resin filler layer after the heat cycle of -65°C - 125°C is repeated 1000 times.

[Water absorption]

It is judged by the presence or absence of crack or peel created in the through-hole portion when the wiring board is immersed in a boiling water for 1 hour.
In Example 1, the bisphenol F-type epoxy resin being solvent-free and relatively soft is used as the resin component of the resin filler, so that the viscosity of the resin filler is low and 45-49 Pa·s at 23±1°C even if it is mixed with silica particles.
As seen from the results of Table 1,

①. the resin filler in Example 1 is excellent in the filling property and the polishing property because the polishing can be conducted without causing the crack or notch,
②. the resin filler in Example 1 has no shrinkage due to the evaporation of the solvent and has an action of preventing the shrinkage through silica particles and hence there is no shrinkage in the curing,
③. the resin filler in Example 1 is made from a solvent-free resin, so that there is caused no interlaminar peel due to the evaporation of the solvent,

④. the resin filler in Example 1 is excellent in the resistance to heat cycle because silica particles make the thermal expansion coefficient of the filled resin small,

⑤. the resin filler in Example 1 can prevent the occurrence of cracks and the like due to water absorption because the water absorption of the resin filler itself can be controlled by the presence of the silica particles not absorbing water.

In Example 2, the bisphenol F-type epoxy resin being solvent-free and relatively soft is used as a resin component of the resin filler and silica particles are not included therein, so that the viscosity of the resin filler is low and is 35 Pa·s at 23±1°C.

As seen from the results of Table 1,

①. the resin filler in Example 2 is excellent in the filling property and the polishing property because the polishing can be conducted without causing the crack or notch,

②. the shrinkage of the resin filler in Example 2 through curing is less because there is no shrinkage due to the evaporation of the solvent. In this example, however, the action of preventing the shrinkage through the silica particles can not be expected, so that there may be observed a case that a space is slightly caused in the through-hole by the shrinkage of the resin itself through the curing.

③. the resin filler in Example 2 is made from a solvent-free resin, so that there is caused no interlaminar peel due to the evaporation of the solvent,

④. the resin filler in Example 2 contains no inorganic particles, so that the resistance to heat cycle and the water absorption are slightly poor as compared with the results of Example 1.

Moreover, when the inorganic particles are not included as in Example 2, it is desirable that bisphenol A-type epoxy resin having a viscosity higher than that of the bisphenol F-type epoxy resin is used in view of the filling property.

In Comparative Example 1, bisphenol A-type epoxy resin is used as the resin component of the resin filler and silica particles are included therein, so that such a resin filler is high in the viscosity and is required to be added with a solvent for ensuring the filling property.

As seen from the results of Table 1,

①. the resin filler in Comparative Example 1 is excellent in the polishing property because the bisphenol A-type epoxy resin is used,

②. the resin filler in Comparative Example 1 contains the inorganic particles, so that the resistance to heat cycle and the water absorption are excellent, but

③. the solvent is evaporated in the curing, so that the shrinkage and also the interlaminar peel are caused even when the resin filler in Comparative Example 1 contains the inorganic particles.

In Comparative Example 2, novolac type epoxy resin having a rigid skeleton is used as a resin component of the resin filler and silica particles are included therein, so that such a resin filler is high in the viscosity and is required to be added with a solvent for ensuring the filling property.

As seen from the results of Table 1,

①. the rein filler in Comparative Example 2 contains the inorganic particles, so that it is excellent in the resistance to heat cycle and the water absorption, but

②. the resin filler in Comparative Example 2 uses the novolac type epoxy resin being hard and brittle, so that the notch and cracks are caused by polishing,

③. the solvent is evaporated in the curing, so that the shrinkage and also the interlaminar peel are caused even when the resin filler in Comparative Example 2 contains the inorganic particles.

In Comparative Example 3, novolac type epoxy resin having a rigid skeleton is used as a resin component of the resin filler, so that the viscosity of the resin filler is high even if silica particles are not included and it is required to add the solvent for ensuring the filling property.

As seen from the results of Table 1,

①. the resin filler in Comparative Example 3 uses the novolac type epoxy resin being hard and brittle, so that the notch and cracks are caused by polishing,

②. the resin filler in Comparative Example 3 causes the shrinkage through the evaporation of the solvent in the curing or the shrinkage of the resin itself due to the absence of the inorganic particle and the interlaminar peel,

③. the inorganic particles are not included, so that the resistance to heat cycle and the water absorption are poor.

(Example 3)

(1) An opening hole for the formation of through-hole is formed by drilling a copper lined glass epoxy laminate substrate (FR-4). Then, the substrate 1 is activated and subjected to electroless copper plating and electrolytic copper plating to form through-holes 9.

(2) The substrate 1 provided with the through-holes 9 in the item (1) is acidically degreased, soft etched and treated with a catalyst solution comprised of palladium chloride and organic acid to give a Pd catalyst, which is activated and subjected to a plating in an electroless plating bath having the following composition to form a roughened layer (uneven layer) 11 of Cu-Ni-P alloy having a thickness of 2.5 $\mu$m on the copper pattern 4 and inner wall of the through-hole 9.

Electroless plating bath (Cu-Ni-P)

| | |
|---|---|
| copper sulfate | : 0.050 mol/l |
| nickel sulfate | : 0.0039 mol/l |
| citric acid | : 0.078 mol/l |
| sodium hypophosphite | : 0.33 mol/l |
| boric acid | : 0.50 mol/l |
| surfactant | : 0.1 g/l |
| pH | : 9.0 |

In this example, the plating bath for the formation of the roughened layer 11 of Cu-Ni-P alloy particularly uses trade name "Interplate process" made by Ebara Ugilite Co., Ltd. The treating conditions are 70°C and 10 minutes.

(3) The substrate after the completion of the treatment of the item (2) is washed with water (and dried, if necessary) and immersed in an electroless tin plating bath comprising tin borofluoride-thiourea solution (or tin chloride-thiourea solution) at 50°C for 1 minute to substitute-form tin plated layer having a thickness of 0.3 $\mu$m on the surface of the roughened layer 11 of Cu-Ni-P alloy.

Moreover, the electroless tin plating is a substitution reaction, so that once the surface of the Cu-Ni-P is substituted with tin plating, the plating reaction does not proceed and the very thin tin plated layer can be formed. And also, the adhesion property between Cu-Ni-P layer and tin plated layer is excellent owing to the substitution reaction.

Substitution plating (tin)

| | |
|---|---|
| tin borofluoride | : 0.1 mol/l |
| thiourea | : 1.0 mol/l |
| temperature | : 50°C |
| pH | : 1.2 |

(4) The resin filler 10 is filled in the through-holes 9 subjected to the above treatment. Moreover, the composition of the resin filler 10 is shown as follows and the filling is carried out by squeeze printing process.

· E807 (made by Yuka Shell Co., Ltd.) :     60 parts by weight
· HN-2200 (made by Hitachi Kasei Co., Ltd.) :     40 parts by weight
· 2E4MZ-CN (made by Shikoku Kasei Co., Ltd. curing agent) :     0.5 wt%
· SiO$_2$ powder (made by Tatsumori Co., Ltd.) :     150 wt%

(5) After the filling of the resin filler 10, the curing treatment is carried out at 80°C for 1 hour, at 100°C for 1 hour, at 120°C for 1 hour and at 150°C for 3 hours (see Fig. 3).

(Example 4)

(1) The substrate 1 provided with the through-holes 9 in the same manner as in Example 3 is degreased, washed with water, treated with acid, subjected to a blackening treatment by immersing in a blackening bath for 6 minutes. Moreover, the blackening bath uses a mixed solution of NaOH (10 g/l), NaClO$_2$ (40 g/l) and Na$_3$PO$_4$ (6 g/l).

(2) The substrate subjected to the treatment of the item (1) is washed with water and subjected to a reduction treatment by immersing in a reducing bath for 1 minute. Moreover, the reducing bath uses a mixed solution of NaOH (10 g/l) and NaBH$_4$.

(3) By repeating the washing of the substrate 1 after the completion of the items (1)(2) is formed a roughened layer (uneven layer) 11 having a roughness of 1.5 $\mu$m - 3 $\mu$m on the inner wall of the through-hole 9.

(4) The resin filler 10 is filled in the through-hole 9 subjected to the above treatment. Moreover, the composition of the resin filler 10 is shown as follows and the filling is carried out by means of a roll coater.

· A-BPE-4 (made by Shin-Nakamura
Kagaku Co., Ltd.) :      80 parts by weight
· E807 (made by Yuka Shell Co., Ltd.) :      20 parts by weight
· 2P4MHZ (made by Shikoku Kasei Co.,
Ltd.) :      5 parts by weight
· DETX (made by Nippon Kayaku Co., Ltd.
curing agent) :      5 parts by weight
· I-907 (made by Chiba Geigy,
curing agent) :      5 parts by weight
· $SiO_2$ powder (made by Fujimi Kenmazai
Kogyo Co., Ltd.) :      100 wt%
· S-65 (made by Sannopco, defoaming
agent) :      0.5 wt%

(5) After the filling of the resin filler 10, the substrate us exposed to an ultraviolet ray at 1000 mj/$cm^2$ and a portion protruding from the surface thereof is polished by buff polishing, which is further cured by heating at 100˚C for 1 hour and at 150˚C for 5 hours.

(Example 5)

(1) The formation of through-holes 9 and the formation of roughened layer (uneven layer) 11 are carried out in the same manner as in Example 3. In this case, the thickness of roughened layer 11 is 1.0 $\mu$m.
(2) The resin filler 10 is filled in the through-hole 9. Moreover, the resin filler 10 has the following composition.

· 828A (made by Yuka Shell Co., Ltd.) :      100 parts by weight
· benzophenone (made by Kanto Kagaku
Co., Ltd. initiator) :      5 parts by weight
· Micheler's ketone (made by Kanto
Kagaku Co., Ltd. initiator) :      0.5 part by weight
· glass fiber :      100 wt%
· F-45 (made by Sannopco, defoaming
agent) :      1 part by weight

(3) After the filling of the resin filler 10, the substrate is exposed to an ultraviolet ray at 1000 mJ/$cm^2$ and a portion protruding from the surface thereof is polished by buff polishing, which is further cured by exposing to an ultraviolet ray at 6000 mJ/$cm^2$.

(Comparative Example 4)

The through-holes 9 are formed in the same manner as in Example 3 and the resin filler 10 having the same composition as in Example 3 is filled in the through-hole 9 without the formation of the roughened layer (uneven layer) 11 (see Fig. 4).

(Comparative Example 5)

The formation of the through-hole 9 and the formation of the roughened layer (uneven layer) 11 are carried out in the same manner as in Example 3. In this case, the thickness of the roughened layer 11 is 0.2 $\mu$m.
Then, the resin filler 10 having the same composition as in Example 3 is filled in the through-hole 9.

(Comparative Example 6)

The formation of the through-hole 9 and the formation of the roughened layer (uneven layer) 11 are carried out in the same manner as in Example 3. In this case, the thickness of the roughened layer 11 is 10 $\mu$m.

Then, the resin filler 10 having the same composition as in Example 3 is filled in the through-hole 9.

With respect to the substrates having the resin filler filled in the through-holes in Examples 3-5 and Comparative Examples 4-6, the property to cool-heat cycle (cycle number of crack occurrence by a test of cool-heat shock of -65˚C⇔125˚C) and presence or absence of liquid penetration in the through-hole by section observation (plating corrosion or occurrence of space at boundary between plated conductor and resin filler) are measured.

The results are shown in Table 2. As seen from the results of this table, according to the structure of the through-hole in the invention, the adhesion property between conductor and resin filler in the inner wall of the through-hole is improved. Therefore, the resistance to cool-heat cycle is excellent and the occurrence of cracks through expansion and shrinkage in the curing can be controlled. Furthermore, it has been confirmed that the space at the boundary between conductor and resin filler in the inner wall of the through-hole in the shrinkage through curing is not caused, so that the penetration of the plating solution or the like can be controlled.

Table 2

| | Kind and thickness or roughness of uneven layer | Test of cool-heat shock *2 | Penetration of liquid*3 |
|---|---|---|---|
| Example 3 | Cu-Ni-P (1 μm) | 2000cyc | none |
| 4 | CuO (2 μm *1) | 2000cyc | none |
| 5 | Cu-Ni-P (1 μm) | 2000cyc | none |
| Comparative Example 4 | - | 1100cyc | presence |
| 5 | Cu-Ni-P (0.2 μm) | 1400cyc | presence |
| 6 | Cu-Ni-P (10 μm) | 1600cyc | none |
| *1: roughness<br>*2: cycle number of crack occurrence by test of cool-heat shock of -65˚C⇔125˚C<br>*3: presence or absence of liquid penetration in the through-hole by section observation (plating corrosion or occurrence of space at boundary between plated conductor and resin filler) | | | |

INDUSTRIAL APPLICABILITY

As mentioned above, the resin filler according to the invention is excellent in the filling property and polishability and less in the shrinkage through curing when inorganic particles are included therein. As a result, the resin filler according to the invention can surely smoothen the surface of the substrate by filling in the concave portion created on the surface of the substrate or in the through-holes formed in the substrate, and has various merits that the resistance to chemicals and water absorption are excellent and the interlaminar peel is not caused and the occurrence of crack and peel due to cool-heat shock is not caused, and the like. Further, when the surface of the substrate is smoothened by the resin filler according to the invention, the thickness of the interlaminar insulating layer can be uniformized, so that the unopening and poor shaping of viahole are not caused.

Moreover, in the multilayer printed circuit board according to the invention using the resin filler according to the invention, particularly provided with the roughened layer in the inner wall of the through-hole, the adhesion property between the inner wall of the through-hole and the resin filler is excellent and the occurrence of crack and the penetration of plating solution or the like can be controlled.

**Claims**

1. A build-up multilayer printed circuit board in which an interlaminar insulating layer (2) and a conductor layer (5, 5') are alternately laminated on both surfaces of a wiring substrate (1) having a conductor circuit and a through-hole (9), and the conductor layers (5, 5') are electrically connected to each other through a viahole (7) formed in the interlaminar insulating layer (2).
   **characterized in that**
   a roughened layer (11) is formed on the surface of the conductor in an inner wall of the though-hole (9), and
   a solvent-free resin filler comprising a bisphenol type epoxy resin cured by an imidazole curing agent and inorganic particles is filled in the through-hole formed in the substrate (1).

2. A build-up multilayer printed circuit board according to claim 1, wherein a surface of the resin filler (10) is polished.

3. A build-up multilayer printed circuit board according to claim 1, wherein the bisphenol type epoxy resin is a bisphenol F-type epoxy resin.

4. A build-up multilayer printed circuit board according to claim 1, wherein the inorganic particles have an average particle size of 0.1~5.0 $\mu$m.

**Patentansprüche**

1. Mehrschichtige Aufbau-Leiterplatte, bei der eine Zwischenschicht-Isolierschicht (2) und eine Leiterschicht (5, 5') abwechselnd auf beide Oberflächen eines Verdrahtungssubstrats (1) geschichtet sind, das eine Leiterschaltung und ein Durchgangsloch (9) aufweist, und bei der die Leiterschichten (5, 5') über ein Kontaktloch (7), das in der Zwischenschicht-Isolierschicht (2) ausgebildet ist, elektrisch miteinander verbunden sind,
   **dadurch gekennzeichnet, dass**
   eine aufgeraute Schicht (11) an der Oberfläche des Leiters in einer Innenwand des Durchgangslochs (9) ausgebildet ist, und
   ein lösungsmittelfreies Harz-Füllmittel, das ein Bisphenol-Epoxidharz, das mittels eines Imidazol-Härtemittels ausgehärtet wird, und anorganische Teilchen umfasst, in das in dem Substrat (1) ausgebildete Durchgangsloch gefüllt ist.

2. Mehrschichtige Aufbau-Leiterplatte nach Anspruch 1, wobei eine Oberfläche des Harz-Füllmittels (10) poliert ist.

3. Mehrschichtige Aufbau-Leiterplatte nach Anspruch 1, wobei das Bisphenol-Epoxidharz ein Epoxidharz vom Bisphenol-F-Typ ist.

4. Mehrschichtige Aufbau-Leiterplatte nach Anspruch 1, wobei die anorganischen Teilchen eine durchschnittliche Teilchengröße von 0,1 - 5,0 $\mu$m haben.

**Revendications**

1. Carte de circuit imprimé multicouche dans laquelle une couche isolante interlaminaire (2) et une couche conductrice (5, 5') sont stratifiées en alternance sur les deux surfaces d'un substrat de câblage (1) ayant un circuit conducteur et un trou traversant (9), et les couches conductrices (5, 5') sont électriquement connectées l'une à l'autre par un trou d'interconnexion (7) formé dans la couche isolante interlaminaire (2) ;
   **caractérisée en ce que**
   une couche rendue rugueuse (11) est formée sur la surface du conducteur dans une paroi interne du trou traversant (9), et
   une charge de résine sans solvant comprenant une résine époxy de type bisphénol durcie par un durcisseur imidazole et des particules inorganiques est remplie dans le trou traversant formé dans le substrat (1).

2. Carte de circuit imprimé multicouche selon la revendication 1, dans laquelle une surface de la charge de résine (10) est polie.

3. Carte de circuit imprimé multicouche selon la revendication 1, dans laquelle la résine époxy de type bisphénol est une résine époxy de type bisphénol F.

4. Carte de circuit imprimé multicouche selon la revendication 1, dans laquelle les particules inorganiques ont une taille moyenne de particule de 0,1 à 5,0 $\mu$m.

Fig. 1

Fig. 2

Fig. 3

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4055555 B
- JP 63137499 A

- US 3953664 A
- EP 0138209 A